# EUROPEAN PATENT APPLICATION

(11) **EP 1 783 892 A1**
(43) Date of publication of application: **09.05.2007**
(21) Application number: 05292323.2
(22) Date of filing: 02.11.2005
(51) Int. Cl.: H03B 5/04, H03L 1/02

(54) **Method for adjusting an OCXO-device**

(71) Applicant: Alcatel Lucent, 75008 Paris (FR)
(72) Inventor: Seur, Kurt, 70825 Korntal (DE)
(74) Representative: Schäfer, Wolfgang

(57) **Abstract**

To provide a system that makes the calibration process of an electronic component (1) more efficient, it is suggested that the calibrating is performed by means of a tuning behaviour, wherein the tuning behaviour of the electronic component (1) is predetermined during or immediately after a manufacturing process.

## Description

The invention relates to a method for calibrating an electronic component by use of a tuning behaviour.

The invention also relates to an electronic component that can be calibrated according to a tuning behaviour.

The invention further relates to a system for re-adjusting an electronic component and to a system for determining a tuning behaviour of an electronic component.

Electronic components are often subject to a re-adjustment procedure. A re-adjustment is often necessary according to changed environmental parameters, such as another environmental temperature or humidity of the outside air. Re-adjustment may also be necessary, when the electronic component is used for different purposes. In particular, an electronic component has to be re-adjusted, due to deviations caused by the electronic component itself. A deviation can be measured according to a predefined specification of the electronic component. Such a specification can comprise for example ranges for input values, ranges for output values, a deviation rate, an amount of distortion, the influence of a changing temperature and the like.

In particular, a deviation from an expected behaviour according to the specification can occur due to an aging of the electronic component. In many environments it is necessary, that the behaviour of an electronic component deviates only very little from an expected behaviour. To ensure that such an electronic component deviates only little from an expected behaviour, a re-adjustment is performed which typically comprises the determination of a current behaviour and then the changing of one or more parameters such that the electronic component again behaves as expected.

An example for such an electronic component is a so-called oscillator. An oscillator is an electronic circuit designed to produce an ideally stable alternating voltage or current. An oscillator in which the frequency is controlled by a piezo-electric crystal is called a crystal oscillator. The frequency that is generated by a crystal oscillator is a function of temperature. Therefore, a crystal oscillator may require controlled temperature to ensure that the generated frequency is stable at least within a given range. There exist different types of crystal oscillators. These include voltage-controlled crystal oscillators (VCXO), temperature-compensated crystal oscillators (TCXO), oven-controlled crystal oscillators (OCXO), temperature-compensated voltage-controlled crystal oscillators (TCVCXO), oven-controlled voltage-controlled crystal oscillators (OCVCXO), microcomputer-compensated crystal oscillators (MCXO), and rubidium crystal oscillators (RbXO).

The OCXO has a temperature controlling circuit to maintain the crystal itself and further elements of the electronic component at a constant temperature. OCXOs are typically used where temperature stabilities in the order of 10 ppb (parts per billion) or better are required. Oscillators with such a stability are referred to as Stratum 3 oscillators. The behaviour of a quartz blank is depending on its ambient temperature. In a temperature range of about 50°C to 100°C, the characteristic of the oscillation shows a quasi-sinusoidal behaviour if the temperature increases or decreases steadily, i.e. +/- few ppb. It is recommended to operate the OCXO at the so-called turn-over point, where the slope of the quasi-sinusoidal function is zero. This means that even if the temperature varies up or down slightly, the change of frequency is minimal. Typically, for an OCXO the operating temperature of the crystal has to be higher, e.g. 10 degrees higher, than the upper limit of the outside temperature range.

Each OCXO has a so-called aging rate that defines how much the generated frequency will change per given time. The aging rate typically is defined as parts per billion (ppb) according to each year. Because of the effect of aging there is a need to re-adjust the frequency of the OCXO from time to time or if necessary to ensure that the OCXO generates a frequency that is stable according to a predefined characteristic of the OCXO.

To perform an adjustment or a re-adjustment of a crystal oscillator the knowledge of the individual tuning behaviour of the crystal oscillator is necessary. Measuring the individual tuning behaviour of a crystal oscillator is denoted as calibrating the crystal oscillator. The individual tuning behaviour thus describes the output frequency of the crystal according to the applied voltage, the so-called control voltage, U_{c}, at a constant temperature. The re-adjustment then comprises setting up the control voltage U_{c} to the best-value, which means that the oscillator operates at its so-called nominal frequency f₀.

During the calibration process, which lasts for example half an hour, the output frequency of the crystal oscillator has to be kept very stable. This stability is achieved by a well-defined warm-up process of the crystal oscillator. The duration of the warm-up depends on several factors, for example the manufacturing date of the crystal oscillator, and typically takes between 24 and 48 hours. A special warm-up bench is provided for performing this pre-heating. The warm-up makes the calibration process very inefficient.

It is, therefore, an object of the present invention to provide a system that makes the calibration process more efficient.

The object is solved by a method for calibrating an electronic component by use of a tuning behaviour, wherein the tuning behaviour of the electronic component is predetermined during or immediately after the manufacturing process.

Typically, during or shortly after the manufacturing process the quality of the electronic component is tested. During this test the tuning behaviour of the electronic component can be determined. The tuning behaviour can then be provided for calibrating, adjusting and re-adjusting the electronic component. This allows to save the extensive warm-up time and the time for performing the measurement when the electronic component is included as a part of an electrical module.

Advantageously, the tuning behaviour is determined during a pre-aging phase of the electronic component, wherein the pre-aging phase is part of the manufacturing process.

Frequently an electronic component cannot be built in an electric module or an electric device shortly after manufacturing the electronic component. Instead, a so-called pre-aging is needed. This is often performed by the manufacturer of the electronic component. Concerning an OCXO, a pre-aging of about 15 to 20 days is required. At the end of this aging period, the OCXO maintains the necessary stability. The measurement of the tuning behaviour can be performed very efficiently during this pre-aging period, because there is no extra time needed to perform the warm-up.

According to a preferred embodiment of the present invention, the tuning behaviour is stored in a memory element. This allows to provide the tuning behaviour very efficiently to the location, where the electronic component is calibrated.

Advantageously, the electronic component is designed as an SMD-component or a PIN-component. An SMD (Surface Mounted Device)-component is mounted on a Printed Circuit Board (PCB). Using SMD-components allows both sides of the PCB to be used for mounting the SMD-components. On the contrary, a PIN-component is mounted on the PCB by conducting the electrical connectors of the electronic component, the so-called PINs, through the PCB. Conducting the PINs makes a manual soldering necessary, which makes the conducting process expensive.

An SMD-component cannot be as easily removed from the PCB as a PIN-component. Thus, according to the state of the art, either a PIN-component is used instead of a SMD-component or the whole electric module that comprises the SMD-component has to be pre-heated to ensure a sufficient stability of the SMD-component when the calibration-process has to be performed. The inventive method can, therefore, be advantageously used in particular for SMD-components. However, the inventive method can also be applied to PIN-components, which means that the pre-heating bench, the pre-heating time and the time to measure the tuning behaviour can be saved.

According to another preferred embodiment of the present invention, the tuning behaviour is stored as a bar code label. This allows to store, provide and read the tuning behaviour of the electronic component in an efficient way.

Advantageously, the bar code label is located on the housing of the electronic component. This ensures, that the parameters that define the tuning behaviour are available when needed. Since usually several data are printed on the housing of the electronic component, such as the manufacturing date, a type number and the like, also printing the tuning behaviour in form of a bar code label on the housing can be done very efficiently.

According to another preferred embodiment, the tuning behaviour is stored on a flash memory. The flash memory can for example be provided together with the electronic component. It also conceivable, that the flash memory is part of the electronic component. This ensures, that the tuning behaviour can be efficiently stored and read from the memory element using state of the art techniques. With a flash memory, also additional information that characterize the behaviour of the oscillator can be stored. These information could comprise, for example, a full matrix of the temperature behaviour and/or a parametrically or even extrapolated aging behaviour.

Advantageously, the flash memory is accessed by means of a 1-wire communication line. This can be especially advantageous, if the flash memory is part of the electronic component, since only one extra PIN at the electronic component is needed to access the tuning behaviour on the flash memory.

According to a further preferred embodiment, a set of sample points is determined to describe the tuning behaviour. This allows to efficiently describe the tuning behaviour. The use of different sample points can reduce the amount of storage and thus the size of the flash memory or the bar code label, since from the set of sample points the function that describes the output frequency in dependence on the control voltage U_{c} can be determined, for example by using approximation and interpolation techniques.

According to an advantageous embodiment of the present invention, a set of equidistant sample points are determined to describe the tuning behaviour, the set of equidistant sample points starts at zero volts and is incremented according to a predefined step, for example 4/10 volts. These values have proven to be in particular efficient for determining the tuning behaviour of an OCXO.

According to a preferred embodiment, the electronic component is used as part of a module within a wireless communications network. Within a wireless communications network, in particular in a base transceiver station, a very stable frequency is needed for data transmission. Therefore, calibration and re-adjustment has to be performed to ensure the needed stability.

Preferably, the wireless communications network is designed according to the GSM (Global System for Mobile telecommunications)- , UMTS (Universal Mobile Telecommunications System), WiMAX (Worldwide interoperability for Microwave Access)-, or 3GPP (3^{rd} Generation Partnership Project)-standard.

Advantageously, additional information characterizing the electronic component are stored in the memory element, in particular a prediction of the aging behaviour or the behaviour of the electronic component according to different operating temperatures. In particular, if the memory element is realised as a flash memory, additional information can be stored easily in the memory element. These information could comprise e.g. information that allow to predict the aging behaviour of the electronic component. This could be realised e.g. by providing information that allow to extrapolate the aging.

Furtheron, is known that the output frequency of the crystal oscillator varies according to the temperature at which the oscillator is operated. This can be described, e.g. by a quasi-sinusoidal function. This function could also be stored in the memory element in an appropriate representation, e.g. by a polynomial that approximates this function.
Further information could also be stored, e.g. the type of the crystal, the cut of the crystal, a recommended interval for re-adjusting, and the like.

The object is also solved by an electronic component that can be calibrated according to a tuning behaviour, wherein the electronic component comprises a memory element, and wherein a predetermined tuning behaviour of the electronic component is stored in the memory element.

According to a preferred embodiment, the electronic component is a crystal oscillator, in particular an OCXO or a TCXO.

Advantageously, the electronic component is an SMD-component. Providing the predetermined tuning behaviour together with an SMD-component allows the SMD-component to be calibrated highly efficiently compared to the state of the art.

Further advantages of the electronic component are described in claims 17 to 22.

The object is also solved by a system for calibrating an electronic component that comprises means for calibrating the electronic component according to a predetermined tuning behaviour. Advantageously, the system for calibrating the electronic component provides means for executing the inventive method.

The object is also solved by a system for determining a tuning behaviour of an electronic component that comprises means to predetermine the tuning behaviour of the electronic component during or immediately after the manufacturing process, such that the tuning behaviour can be used as input to a system for calibrating the electronic component.

The object is further solved by a computer program that can be run on a computer system, in particular on a system for calibrating an electronic component and/or a system for predetermining a tuning behaviour of the electronic component.

Further features and advantages of the present invention are explained in more detail below with reference to the accompanying drawings. The figures show:
- Fig. 1: a schematically simplified OCXO;
- fig. 2: a schematical flow chart of the calibration process; and
- fig. 3: a schematical flow chart of the re-adjusting process.

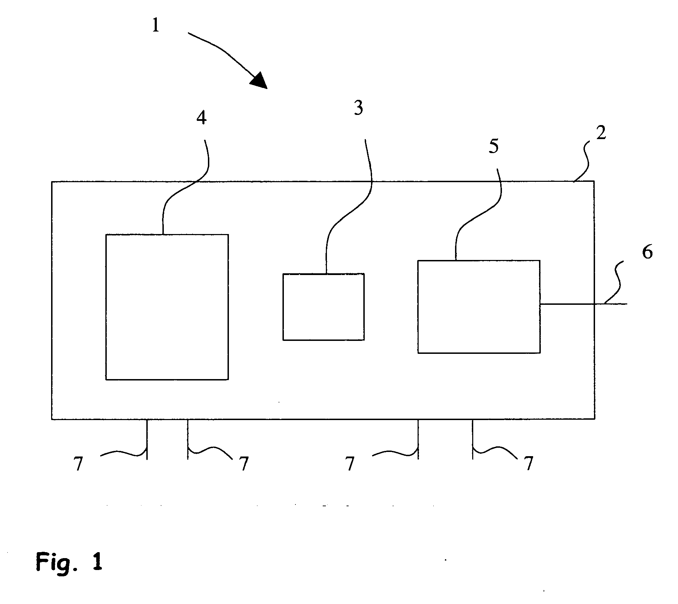

Fig. 1 shows an oven-controlled crystal oscillator (OCXO) 1, comprising a housing 2. The housing 2 encloses a crystal 3 and a heating circuit, the so-called oven 4. The housing 2 further encloses a memory element 5. The memory element 5 is accessible through a communication line 6.

The OCXO 1 further comprises several PINs 7 that allow to establish an electrical connection between the OCXO 1 and a circuit board (not shown in fig. 1), e.g. a Printed Circuit Board (PCB).

The crystal 3 generates an oscillating output signal that can be accessed through a predefined PIN 7. To increase the stability of the oscillating output signal the crystal 3 is heated by the oven 4. Therefore, a voltage is applied to the oven 4 through predefined PINs 7. Heating the crystal 3 by the oven 4 also isolates the temperature of the crystal 3 from the outside temperature, since fluctuations of the outside temperature can be compensated.

The memory element 5 can be embodied as any suited memory media, in particular as a flash memory. Data can be written to an read from the memory element 5 through the communications line 6 that enables a serial communication. It is also conceivable, that the memory element 5 can be accessed via a wireless communication, e.g. a bluetooth or a WLAN connection or via an electro-magnetic field.

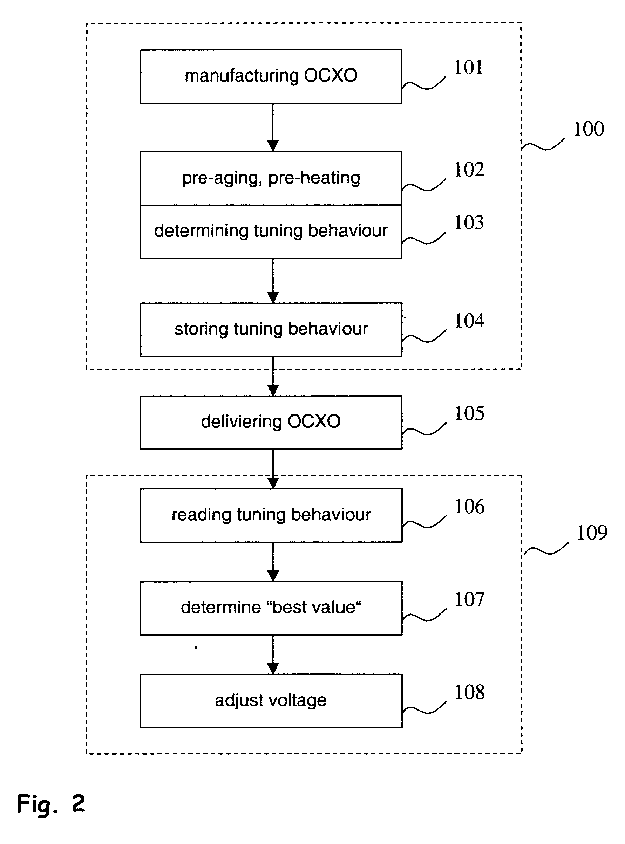

Fig. 2 shows an exemplified realisation of the inventive method. The method shown in fig. 2 comprises steps 101 to 108. The steps 101, 102, 103 and 104 are carried out in a manufactory that is manufacturing the crystal oscillator 1. This is shown by the dashed line 100. Steps 106, 107 and 108 are carried out in a factory where the crystal oscillator 1 is assembled into a module, e.g. a module that is used within a wireless communications network. These steps are surrounded by the dashed line 109. The module can be, for example, a so-called Base Transceiver Station (BTS). Within the GSM-communications network the BTS is part of the so-called Base Station Subsystem (BSS). The BSS controls the radio link between a mobile terminal and a base station. To enable a stable communications link, the BTS needs a very stable clock signal which is generated by the crystal oscillator 1.

In the step 101 the crystal oscillator 1 is manufactured.

In the step 102 a pre-aging of the crystal oscillator 1 is performed. This is necessary to ensure, that the crystal oscillator 1 generates a clock signal according to a predefined stability. To perform the pre-aging, the crystal oscillator 1 is run e.g. in a simulated environment. This usually includes applying a voltage to the oven 4.

The process of pre-aging usually lasts about 15 to 20 days. During these days, the crystal oscillator 1 is run in the simulated environment, in particular simulating real conditions.

According to the state of the art, the process of calibration is done in the factory where the crystal oscillator 1 is assembled into the module. This needs the crystal oscillator 1 to be fixed on a so-called test bench. To measure the behaviour of the crystal oscillator 1, the crystal oscillator 1 first has to be pre-heated. This typically lasts up to 24 hours.

According to the present invention, the pre-heating is done implicitly when the crystal oscillator 1 is operated during the pre-aging process. To perform the calibration of the crystal oscillator 1, first the tuning behaviour has to be determined. The tuning behaviour describes the frequency of the clock signal at the ratio of the voltage that is applied to the crystal oscillator.

The ratio of the frequency according to the applied voltage can be determined by measuring the frequency of the generated clock signal at predefined voltage values. The predefined voltage values realise so-called sample points.

In the step 103 these measurements are performed. This can be done while the crystal oscillator 1 is in the pre-aging process. In particular, the measurement is performed at the end of the pre-aging process. The measurements can also be performed shortly after the pre-aging process. Performing the measurements during the pre-aging process has the advantage, that no special pre-heating has to be performed, since the crystal oscillator 1 is heated by the oven 4 during the simulation of a normal operation.

The measurement can be performed by measuring the generated frequency of the crystal oscillator 3 according to 11 predefined voltage values. If, for example, the range of normal operation of the OCXO 1 is between 0 volts and 4 volts, 11 equidistant sample points can be chosen, starting from 0 volts to 4 volts in steps of 0.4 volts.

In the step 104 the values that are measured in the step 103 are stored in the memory element 5. Therefore, the measured values can be transmitted to the memory element 5 using the communications line 6.

It is conceivable, that the measured values are coded as a two-dimensional bar code. This bar code could then be printed on the housing 2 of the OCXO 1.

In the step 105 the manufactured and pre-aged OCXO 1 is delivered to the factory, where the OCXO is assembled within another electronic module, e.g. a BTS. According to the state of the art, the tuning behaviour of the OCXO 1 had to be determined in this factory. Therefore, a pre-heating had to be performed. This usually took about 24 hours.

However, according to the present invention, the tuning behaviour is determined as described in step 103 in the manufactory. Thus, the tuning behaviour that is stored in the memory element 5 has just to be read in the step 106. This can be done for example by accessing the memory element 5 via the communications line 6 or by reading the bar code that is printed on the housing 2.

In the step 107 the so-called best-value is determined. The best-value defines the point at which the crystal oscillator 3 operates at a so-called nominal frequency. The nominal frequency of an OCXO is, for example, f₀ = 26.0000 MHz. Thus, the best-value is the point and thus the setting of the control voltage, at which _{Δ}f/f₀ = 0.

The function that describes the frequency in dependence of the voltage can be determined using the tuning behaviour, i.e. the values that are measured in step 103. This could be done by performing an approximaton. In particular, the function can be described by a polynomial of 9^{th} degree. Therefore, an interpolation can be performed using the appropriate number of sample points.

In the step 108 the OCXO 1 is adjusted according to the best-value. Therefore, the module in which the OCXO 1 is assembled, is configured such that the OCXO 1 is applied with the appropriate voltage. The best-value is determined such that _{Δ}f/f₀ = 0.

According to the present invention, the calibration process is shifted at least partly from the factory, where the OCXO 1 is assembled into a module, to the manufactory where the OCXO 1 is manufactured. Thus, determining the tuning behaviour of the OCXO 1 needs no extra pre-heating which means that time can be saved. In addition, the OCXO 1 has not to be placed in a special test bench at the factory for performing the measurements. Instead, this is now done in the manufactory while the pre-aging is performed.

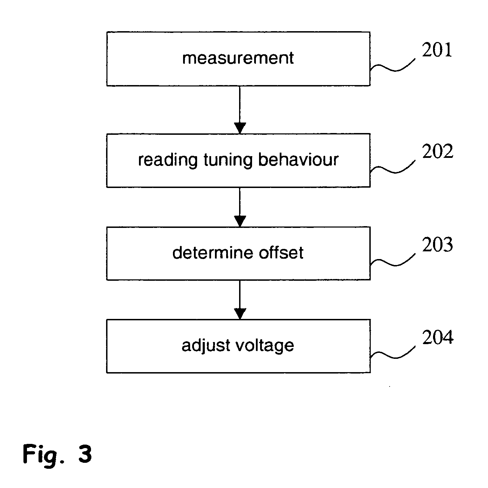

In fig. 3 an example for the process of re-adjusting of the OCXO 1 is shown.

Generally, crystal oscillators 3 are subject to aging. Aging means, in particular the change of the frequency of the generated clock signal due to even a slightest variance of the mass of the crystal that is part of the crystal oscillator 3. Aging can occur due to dust particles that permeate into the housing 2.

To compensate the negative facts of aging a so-called re-adjusting is performed. According to the example shown in fig. 3, in a step 201 current values are measured. These values define for example the frequency of the generated clock signals according to the last best value, i.e. the U_{c} as set so far. This measurement can be performed during normal operation or during a special re-adjusting phase.

The effect of aging can be described as an offset to the function that describes the frequency in dependence of the voltage. This means that the frequency of the generated clock signal will be higher or lower than the original values.

In a step 202 the tuning behaviour that is stored in the memory element 5 is read. This can be done according to step 106.

In a step 203 the offset is determined using the measured values in the step 201 and the tuning behaviour that is read in step 202.

In a step 204 the re-adjusting is performed in that the voltage at which the crystal oscillator 3 is operated is adjusted to compensate the offset. This can be performed by a software element that is attached to the module in which the OCXO 1 is assembled.

Several further embodiments according to the present invention are conceivable.

For example, the tuning behaviour can be stored coded as a two-dimensional bar code label that is printed on the housing 2 of the OCXO 1. Using a bar code reader the tuning behaviour can be read for example in the step 106 or in the step 202.

Furtheron, the order of the steps of the inventive method can be changed, as long as the basic idea of the present invention is preserved. For example, the order of the steps 201 and 202 can be changed or be executed in parallel.

It is further conceivable, that the tuning behaviour of the OCXO 1 is stored in a memory element that is attached to the module, e.g. the BTS, in which the OCXO is assembled. Therefore, it is conceivable that both, the module and the electronic element comprise a memory element and that the tuning behaviour is copied from the memory element that is attached to the electronic element, e.g. the flash memory or the bar code label, into the memory element, that is attached to the whole module. This could simplify the access to the tuning behaviour, e.g. for re-adjusting the electronic component, in particular if the memory element that is attached to the electronic component is realised as a bar code label.

This would mean, that adjusting and re-adjusting the OCXO can be performed e.g. using a software interface that is attached to the module and/or via a varactor at the tuning input.

One or more steps of the method shown in fig. 2 and fig. 3 can be added, removed or exchanged, as long as the inventive idea is preserved. For example, the steps 201 and 202 can be exchanged or performed in parallel. It is further possible, that the offset in step 203 is determined without need to read the stored tuning behaviour.

It is further conceivable, that the measurement performed in step 103 is performed from the manufactory after the pre-aging, e.g. in a separated measurement process. It is even conceivable, that this measurement process needs an extra pre-heating, as long as the basic idea of the invention, i.e. the determination of the tuning behaviour in a process that is separated from the determination of the best-value, is preserved.

The number of sample points mentioned within this document have to be understand as an example. According to the tuning behaviour that is determined and the function that is approximated, another number of sample points could be advantageous. This can e.g. depend on the degree of the polynomial used to describe the function.

The same holds for the distance between the sample points. To realise the basic idea of the invention, the sample points need not be equidistant. But equidistant sample points can be advantageous, according to the function that has to be interpolated and e.g. the domain of the input and/or output values of this function and thus the domain of the sample points itself.

## Claims

1. Method for calibrating an electronic component (1), **characterized in that** the calibration is performed by means of a tuning behaviour and the tuning behaviour of the electronic component (1) is predetermined during or immediately after a manufacturing process (100).

2. The method of claim 1, **characterized in that** the tuning behaviour is determined during a pre-aging period (102) of the electronic component (1), wherein the pre-aging period (102) is part of the manufacturing process (100).

3. The method of claim 1 or 2, **characterized in that** the tuning behaviour is stored on a memory element (5).

4. The method according to any one of the preceding claims, **characterized in that** the electronic component (1) is a temperature controlled crystal oscillator (TCXO) or a oven (4) controlled crystal oscillator (OCXO).

5. The method according to any one of the preceding claims, **characterized in that** the electronic component (1) is designed as an SMD-component or a PIN-component.

6. The method according to any one of claim 3 to 5, **characterized in that** the tuning behaviour is stored as a bar code label.

7. The method of claim 6, **characterized in that** the bar code label is located on a housing (2) of the electronic component (1).

8. The method according to any one of claim 3 to 7, **characterized in that** the tuning behaviour is stored on a flash memory.

9. The method of claim 8, **characterized in that** the flash memory is accessed by means of a 1-wire communication line (6).

10. The method according to any one of the preceding claims, **characterized in that** a set of sample points is determined to describe the tuning behaviour.

11. The method according to any one of the preceding claims, **characterized in that** equidistant sample points are determined to describe the tuning behaviour, in particular equidistant sample points starting at 0 Volts and being incremented in steps of 4/10 Volts.

12. The method according to any one of the preceding claims, **characterized in that** the electronic component (1) is used as part of a module within a wireless communications network, in particular in a GSM-, UMTS-, WiMAX-, or 3GPP-network.

13. The method according to any one of claim 3 to 12, **characterized in that** additional information characterizing the electronic component are stored in the memory element (5), in particular a prediction of the aging behaviour or the behaviour of the electronic component (1) according to different operating temperatures.

14. Electronic component (1) that can be calibrated **characterized in that** the electronic component comprises a memory element (5), wherein a predetermined tuning behaviour of the electronic component is stored in the memory element (5).

15. The electronic component (1) of claim 14, **characterized in that** the electronic component is a crystal oscillator (3), in particular an OCXO or a TCXO.

16. The electronic component (1) of claim 14 or 15, **characterized in that** the electronic component (1) is an SMD-component or a PIN-component.

17. The electronic component (1) according to any one of claim 14 to 16, **characterized in that** the memory element (5) is a bar code tag or a flash memory

18. The electronic component (1) according to any one of claim 14 to 17, **characterized in that** the tuning behaviour comprises equidistant sample points.

19. The electronic component (1) according to any one of claim 14 to 18, **characterized in that** the electronic component (1) is part of a module within a wireless communication network, in particular a GSM, an UMTS, a WiMAX or a 3GPP network.

20. The electronic component (1) of claim 19, **characterized in that** the module comprises at least parts of the functionality of a base station.

21. System for calibrating an electronic component (1), **characterized in that** the system comprises means for determining a tuning behaviour of the electronic component (1) during or immediately after a manufacturing process (100) and means for calibrating the electronic component (1) according to the predetermined tuning behaviour.

22. The system of claim 21, **characterized in that** the system comprises means for executing a method according to any one of claim 1 to 13.

23. System for determining a tuning behaviour of an electronic component (1), **characterized in that** the system comprises means to predetermine the tuning behaviour of the electronic component (1) during or immediately after the manufacturing process (100), wherein the tuning behaviour can be used as input to a system for adjusting the electronic component (1) according to claim 21 or 22.

24. Computer program that can be run on a computer system, in particular on a system for adjusting an electronic component (1) and/or a system for determining a tuning behaviour of the electronic component (1), **characterized in that** the computer program is programmed to execute the method according to any one of claim 1 to 13 when it is run on the computer system.
